# EUROPÄISCHE PATENTSCHRIFT

(11) **EP 3 738 415 B1**
(45) Veröffentlichungstag und Bekanntmachung des Hinweises auf die Patenterteilung: **09.11.2022**
(21) Anmeldenummer: 19720452.2
(22) Anmeldetag: 15.04.2019
(51) Int. Cl.: H05K 7/14, H05K 1/14, H05K 1/18, H05K 3/32

(54) **BACKPLANE UND VERFAHREN ZU DEREN HERSTELLUNG**
BACKPLANE AND METHOD FOR ITS MANUFACTURE
FOND DE PANIER ET SON PROCÉDÉ DE FABRICATION

(30) Priorität: 25.04.2018 EP 18169231
(43) Veröffentlichungstag der Anmeldung: 18.11.2020
(73) Patentinhaber: Siemens Aktiengesellschaft, 80333 München (DE)
(72) Erfinder: SEIDL, Joachim, 92237 Sulzbach-Rosenberg (DE)
(86) Internationale Anmeldenummer: PCT/EP2019/059615
(87) Internationale Veröffentlichungsnummer: WO 2019/206700

(56) Entgegenhaltungen:
- EP-A1- 1 553 630
- EP-A1- 2 916 393
- EP-A2- 0 643 451
- EP-A2- 1 311 146
- DE-A1-102016 002 052
- DE-A1-102016 217 236
- US-A1- 2012 195 548

## Beschreibung

Die Erfindung betrifft eine Backplane zum elektrischen Verbinden elektrischer Bauelemente und ein Verfahren zur Herstellung einer derartigen Backplane. Ferner betrifft die Erfindung einen Schaltschrank.

Unter einer Backplane wird hier ein Träger für elektrische Bauelemente verstanden, der Leiterbahnen zum elektrischen Verbinden der elektrischen Bauelemente aufweist. Derartige elektrische Bauelemente sind beispielsweise Relais, Schütze, Schalter, Steuerungseinheiten oder Eingabe-/Ausgabeeinheiten. In einem Schaltschrank werden elektrische Bauelemente einer technischen Vorrichtung oder Anlage angeordnet. In herkömmlichen Schaltschränken werden elektrische Bauelemente in der Regel manuell durch Kabel elektrisch miteinander verbunden. Bei einer Vielzahl elektrischer Bauelemente entsteht dabei ein hoher Verkabelungsaufwand.

DE102016002052A1 (Liebherr-Components Biberach GmbH) 22.06.2017 offenbart einen Schaltschrank und ein Verfahren zu dessen Herstellung. Der Schaltschrank weist zumindest eine Schalttafel mit einer Grundplatte auf, auf der elektrische Schaltelemente angeordnet und miteinander elektrisch verbunden sind. Die zumindest eine Grundplatte und/oder zumindest eines der Schaltelemente wird mittels eines 3D-Druckers in einem 3D-Druckverfahren hergestellt.

US2012/195548A1 (Brunner Robert et al.) 02. August 2012 beschreibt eine Backplane 101 zum elektrischen Verbinden von Circuit Boards 301, wobei die Backplane 101 eine Trägerplatte (Printed Circuit Board), auf und/oder in der Trägerplatte verlaufende Leiterbahnen und auf oder in der Trägerplatte angeordnete Aktoreinheiten, z.B. Optical Switches 105 und einen Backplane Controller 103, umfasst.

Der Erfindung liegt die Aufgabe zugrunde, eine hinsichtlich ihrer Funktionalität verbesserte Backplane, ein Verfahren zur Herstellung einer derartigen Backplane und einen verbesserten Schaltschrank anzugeben.

Die Aufgabe wird erfindungsgemäß durch eine Backplane mit den Merkmalen des Anspruchs 1, einen Schaltschrank mit den Merkmalen des Anspruchs 8 und ein Verfahren mit den Merkmalen des Anspruchs 9 gelöst.

Eine erfindungsgemäße Backplane zum elektrischen Verbinden elektrischer Bauelemente umfasst eine Trägerplatte, auf und/oder in der Trägerplatte angeordnete Leiterbahnen und zwei oder mehr in die Trägerplatte integrierte, d. h. auf oder in der Trägerplatte angeordnete, Aktoreinheiten.

Eine erfindungsgemäße Backplane weist somit neben Leiterbahnen auch zwei oder mehr in die Backplane integrierte Aktoreinheiten auf.

Unter einer Aktoreinheit wird jede Art von elektrischen Bauelementen verstanden, die eine Aktion ausführen. Insbesondere werden darunter Schalt- und Schutzgeräte verstanden, d.h. alle Geräte, die elektrisch angesteuert werden können, um eine Aktion auszuführen. Insbesondere setzen Aktoreinheiten elektrische Signale, z. B. von einer Steuerungseinheit ausgehende Befehle, in eine mechanische Bewegung oder andere physikalische Größen, z. B. Druck oder Temperatur, um. Aktoreinheiten können als ein signalwandler-bezogenes Gegenstück zu Sensoreinheiten betrachtet werden. Sie setzen Signale einer Regelung in zumeist mechanische Arbeit um, z. B. ein Öffnen und Schließen eines elektrischen Schaltkontakts. Eine Aktoreinheit kann als ein elektro-mechanisches Gerät ausgebildet sein, z. B. ein Relais mit einem mechanisch bewegten Kontakt. In diesem Fall kann die Aktoreinheit vorzugsweise als ein Mikrosystem, insbesondere ein MEMS, ausgebildet sein (MEMS = Micro-Electro-Mechanical System). Solche MEMS werden in Herstellverfahren gefertigt, die denen zur Herstellung von Halbleiterelementen ähneln, und können genauso wie Halbleiterelemente, z. B. Transistoren oder Thyristoren, direkt in die Trägerplatte integriert und elektrisch kontaktiert werden. Alternativ kann eine Aktoreinheit als ein Element ohne mechanische Elemente ausgebildet sein, insbesondere als ein Halbleiterelement wie z. B. ein Thyristor.

Eine Aktoreinheit kann ein elektrisches Gerät bzw. Bauelement aus folgender Gruppe sein: elektrische Sicherung, z. B. Schmelzsicherung oder wiedereinschaltbare Sicherung, insbesondere Sicherungsautomat; Relais; Schütz; Motorschutzschalter; Motorstarter; Sanftstarter.

Eine Aktoreinheit kann auch ein elektrischer Kontakt in einer Ausgangsbaugruppe einer SPS sein, z. B. ein Optokoppler, ein (Print-)Relais, ein elektronisches Schaltelement (SPS = Speicherprogrammierbare Steuerung, englisch: PLC = Programmable Logic Controller).

Eine Aktoreinheit kann auch eine bestückte Leiterplatte (engl.: PCB = Printed Circuit Board) sein. Eine Aktoreinheit kann auch eine bestückte Leiterplatte mit integrierter Ausgabebaugruppe sein. Eine Leiterplatte (englisch: PCB = Printed Circuit Board) ist ein Träger für elektronische Bauteile. Die Bezeichnung "bestückte Leiterplatte" steht dabei für alle Arten einer elektronischen Flachbaugruppe, bei der diskrete und/oder integrierte elektrische bzw. elektronische Bauelemente auf einer als ein Schaltungsträger dienenden Leiterplatte zu einer elektronischen Schaltung verbunden sind. Beispiele für elektronischen Bauelemente sind Printrelais, Stecker, Ein-/Ausgabe-Baugruppen, Steuer- und Recheneinheiten.

Eine als eine Leiterplatte ausgebildete Aktoreinheit kann in die Trägerplatte integriert sein, d. h. auf oder in der Trägerplatte angeordnet sein. Dabei kann es sich um eine Integration einer herkömmlich bestückten Flachbaugruppe in eine mittels AM-Verfahren hergestellte Backplane handeln (AM = Additive Manufacturing). Dies stellt eine Kombination der jeweiligen Vorteile der Fertigungsverfahren AM und Diskrete Bestückung dar. Die hohe Flexibilität inklusive der Möglichkeiten von Funktionsintegration wird durch eine mittels AM-Verfahren hergestellte Backplane, kurz: AM-Backplane, ermöglicht. Eine in die Trägerplatte integrierte herkömmliche Flachbaugruppe kann eingesetzt werden, wenn eine mittels AM-Verfahren hergestellte Flachbaugruppe nicht möglich ist oder zu viele Nachteile hat. Zudem eignet sich eine herkömmlich bestückte Flachbaugruppe insbesondere für alle Komponenten, die mit größerer Stückzahl und/oder Wiederholrate hergestellt werden. Außerdem bietet eine herkömmliche Flachbaugruppe die Möglichkeit, als eine Trägerplatine für Stecksockel zu dienen. Eine Flachbaugruppe wird vorzugsweise durch an der Flachbaugruppe angebrachte Kontaktelemente mit entsprechenden Kontaktelementen in der AM-Backplane in Verbindung gebracht. Diese elektrische Kontaktierung kann fest oder lösbar ausgeführt werden. Die elektrische Kontaktierung kann mittels Schraub-, Klemm-, Steck-, Löt-, Stift- oder weiteren Kontaktierungsmethoden erfolgen. Die Befestigung und Kontaktierung der Flachbaugruppe in der AM-Backplane erfolgt vorzugsweise so, dass ein Austausch der Flachbaugruppe möglich ist, z. B. im Fehlerfall einer Komponente auf der Platine.

Vorteile von elektronischen Aktoren sind eine sehr hohe, nahezu unbegrenzte Schalthäufigkeit und eine sehr hohe Schaltgeschwindigkeit, während sich elektromechanische Aktoren durch eine hohe Schaltleistung und eine galvanische Trennung von Kontakten auszeichnen.

Die erfindungsgemäße Integration von zwei oder mehr Aktoreinheiten direkt in oder auf die Trägerplatte macht es möglich, dass eine individuelle Verdrahtung zwischen den einzelnen elektrischen Bauelementen, insbesondere einer Steuereinheit, den Aktoreinheiten und den Ausgangskontakten, automatisiert hergestellt werden kann; somit entfällt eine aufwändige und fehleranfällige "Handverdrahtung", d.h. ein manuelles elektrische Verbinden der verschiedenen elektrischen Bauelemente mithilfe von Kabeln. Aufgrund der automatisierten individuelle Verdrahtung, insbesondere durch eine Kontaktierung einer Aktoreinheit durch die in und/oder auf der Trägerplatte angeordnete Leiterbahnen, können ohne großen Aufwand für jeden Kunden individuell angefertigte Backplanes hergestellt werden, d. h. eine Backplane mit Losgröße 1 generiert werden.

Durch die Integration von Aktoreinheiten während der Additiven Fertigung direkt in die Trägerplatte können die einzelnen Aktoreinheiten jeweils unter Berücksichtigung einer minimalen Leitungslänge, einer minimalen Beeinflussung durch Abstrahlung von EMV, einer maximalen Wärmeabgabe, etc. automatisiert platziert werden (EMV = Elektromagnetische Verträglichkeit). Dabei können einzelne Aktoreinheiten direkt in die Trägerplatte integriert werden und durch die ebenso in der Trägerplatte integrierten, d.h. auf und/oder in der Trägerplatte angeordneten, Leitungen miteinander verbunden, also kontaktiert werden.

Ein erfindungsgemäßer Schaltschrank weist eine erfindungsgemäße Backplane auf. Die Verwendung einer erfindungsgemäßen Backplane in einem Schaltschrank reduziert vorteilhaft den Aufwand und die Kosten zum elektrischen Verbinden elektrischer Bauelemente in dem Schaltschrank gegenüber dem herkömmlichen Verbinden elektrischer Bauelemente durch Kabel.

Bei dem erfindungsgemäßen Verfahren zur Herstellung einer erfindungsgemäßen Backplane werden die zwei oder mehr Aktoreinheiten durch einen 3D-Druck in die Trägerplatte integriert. Beispielsweise wird die wenigstens eine Aktoreinheit in die Trägerplatte integriert, indem die Trägerplatte wenigstens in einem die Aktoreinheit umgebenden Bereich mit einem 3D-Druck hergestellt wird, der die Aktoreinheit in die Trägerplatte einbettet. Unter einem 3D-Druck wird ein Verfahren verstanden, bei dem ein dreidimensionales Objekt durch computergesteuertes schichtweises Auftragen von Material hergestellt wird.

Die Integration einer Aktoreinheit durch einen 3D-Druck in die Trägerplatte, insbesondere durch eine Einbettung der Aktoreinheit in die Trägerplatte mittels eines 3D-Drucks, ermöglicht eine effiziente Bestückung der Trägerplatte mit der Aktoreinheit. Insbesondere entfallen eine aufwändige nachträgliche Befestigung der Aktoreinheit auf der Trägerplatte und dafür erforderliche Befestigungsstrukturen.

Vorteilhafte Ausgestaltungen und Weiterbildungen der Erfindung sind in den abhängigen Ansprüchen angegeben. Dabei kann das erfindungsgemäße Verfahren auch entsprechend den abhängigen Vorrichtungsansprüchen weitergebildet sein, und umgekehrt.

Ausgestaltungen der Erfindung sehen vor, dass wenigstens eine Aktoreinheit einen Stromsensor zum Erfassen eines elektrischen Stroms aufweist, und/oder dass wenigstens eine Aktoreinheit einen Spannungssensor zum Erfassen einer elektrischen Spannung aufweist, und/oder dass wenigstens eine Aktoreinheit einen Leistungssensor zum Erfassen einer elektrischen Leistung aufweist. Die vorgenannten Ausgestaltungen der Erfindung ermöglichen insbesondere, die Funktion von Aktoreinheiten durch die Erfassung von durch die Aktoreinheiten fließenden elektrischen Strömen, an den Aktoreinheiten anliegenden elektrischen Spannungen und/oder über die Aktoreinheiten übertragenen elektrischen Leistungen zu überwachen und insbesondere Fehlfunktionen und Ausfälle von Aktoreinheiten zu erkennen. Ferner ermöglichen sie beispielsweise, elektrische Überspannungen und Überströme zu erkennen, um elektrische Bauelemente erforderlichenfalls abzuschalten und eine Schädigung oder Zerstörung der elektrischen Bauelemente zu verhindern.

Durch geeignete Sensoreinheiten kann die Funktion von Aktoreinheiten und Leiterbahnen, insbesondere bereits während der Inbetriebnahme der Backplane, und/oder Betriebsbedingungen der Backplane erfasst und überwacht werden. Dadurch können vorteilhaft die Betriebssicherheit und die elektrische Zuverlässigkeit der Backplane erhöht werden, beispielsweise indem die Instandhaltung der Backplane unter Berücksichtigung der erfassten Sensorsignale durchgeführt wird. Die von einer Sensoreinheit erfassten Sensorsignale können beispielsweise einer übergeordneten Applikation verfügbar gemacht werden. Insbesondere können die Sensorsignale in eine Datenwolke (Cloud) übertragen und in dieser ausgewertet und/oder verwendet werden. Zum Datenaustausch zwischen der Backplane und der übergeordneten Applikation oder zwischen der Backplane und einer Cloud kann die Backplane, in der die Server angeordnet sind, ein Interface aufweisen. Die Datenübertragung zwischen einem Sensor und einer mit dem Sensor in Datenaustausch stehenden Einheit kann mittels eines Standards zum Datenaustausch wie Profinet, Ethernet, Modbus, OPC (= Open Platform Communications) erfolgen.

Gemäß einer bevorzugten Ausgestaltung der Erfindung weist die Backplane wenigstens ein an den zwei oder mehr Aktoreinheiten angeordnetes Abschirmelement zum Abschirmen elektrischer und/oder magnetischer Felder auf. Durch eine Aktion der zwei oder mehr Aktoreinheiten, z. B. durch ein Öffnen oder ein Schließen eines elektrischen Kontaktes, werden im Leitungsnetz der Backplane transiente Vorgänge hervorgerufen, was z. B. zu elektrische Störimpulsen führen kann. Durch ein an den zwei oder mehr Aktoreinheiten angeordnetes Abschirmelement können unerwünschte elektromagnetische Störungen anderer Bauelemente der Backplane oder von Bauelementen im Schaltschrank verringert werden. Durch eine Positionierung des Abschirmelements nahe an der Störungsquelle, d. h. an den zwei oder mehr Aktoreinheiten, z. B. durch ein die Aktoreinheit einhüllendes Abschirmelement, können elektromagnetische Störungen sehr effektiv reduziert werden.

Gemäß einer bevorzugten Ausgestaltung der Erfindung weist die Backplane wenigstens ein an den zwei oder mehr Aktoreinheiten angeordnetes Kühlelement zur Kühlung der Aktoreinheiten auf. Durch eine Aktion der zwei oder mehr Aktoreinheiten, z. B. durch ein Öffnen oder ein Schließen eines elektrischen Kontaktes, entsteht Wärme, z. B. aufgrund eines Mikrolichtbogens oder eines Übergangswiderstands zwischen den Kontakten eines elektrischen Schalters. Durch ein an den zwei oder mehr Aktoreinheiten angeordnetes Kühlelement können unerwünschte Erwärmungen anderer Bauelemente der Backplane oder von Bauelementen im Schaltschrank verringert werden. Durch eine Positionierung des Kühlelements nahe an der Wärmequelle, d. h. an den zwei oder mehr Aktoreinheiten, z. B. durch einen die Aktoreinheiten umschließenden Kühlkanal, können unerwünschte Wärmeeinträge sehr effektiv reduziert werden.

Die Integration der zwei oder mehr Aktoreinheiten in die Trägerplatte, d. h. die Anordnung der zwei oder mehr Aktoreinheiten auf oder in der Trägerplatte, kann durch verschiedene Verfahren erfolgen. Eine erste Möglichkeit besteht in einer Einbettung einer Aktoreinheit in die Trägerplatte während der additiven Fertigung der Backplane, wobei die elektrische Kontaktierung der jeweiligen Aktoreinheit, d. h. die elektrische Verbindung der Kontaktflächen der Aktoreinheit mit Leiterbahnen der Backplane, in einem vor- oder nachgelagerten Fertigungsschritt während des additiven Fertigungsprozesses erfolgt. Ein nachträglicher Austausch der Aktoreinheit ist nicht mehr zerstörungsfrei möglich, da die Aktoreinheit vom 3D-Material umschlossen ist. Gemäß einer bevorzugten Ausgestaltung der Erfindung ist also die Trägerplatte wenigstens in einem die Aktoreinheit umgebenden Bereich mit einem 3D-Druck hergestellt, so dass die Aktoreinheit in die Trägerplatte einbettet ist. Gemäß einer bevorzugten Ausgestaltung der Erfindung werden die zwei oder mehr Aktoreinheiten in die Trägerplatte integriert, indem die Trägerplatte wenigstens in einem die Aktoreinheit umgebenden Bereich mit einem 3D-Druck hergestellt wird, der die Aktoreinheit in die Trägerplatte einbettet.

Eine andere Möglichkeit besteht in einem Einsetzen einer Aktoreinheit in eine in der Trägerplatte vorgesehene Aufnahme, wobei ein nachträglicher Austausch der jeweiligen Aktoreinheit möglich ist. Gemäß einer weiteren bevorzugten Ausgestaltung der Erfindung sind also die zwei oder mehr Aktoreinheiten herausnehmbar in eine Aussparung der Trägerplatte eingesetzt. Gemäß einer weiteren bevorzugten Ausgestaltung der Erfindung werden die zwei oder mehr Aktoreinheiten in die Trägerplatte integriert, indem in der Trägerplatte eine Aussparung vorgesehen wird, worin die zwei oder mehr Aktoreinheiten eingesetzt wird.

Gemäß einer bevorzugten Ausgestaltung der Erfindung sind die zwei oder mehr Aktoreinheiten mithilfe von Federelementen, insbesondere elektrisch leitfähigen Federelementen, in der Aussparung der Trägerplatte fixiert. Dabei kann es sich um an einer Aktoreinheit angeordnete Federelemente, z. B. Metallfedern, handeln, welche elektrische Kontaktflächen der Aktoreinheit aufweisen. Durch die Federkraft der Federelemente wird eine an dem Federelement angeordnete Kontaktfläche der Aktoreinheit an eine in die Trägerplatte integrierte Leiterbahn angepresst, so dass ein zuverlässiger elektrischer Kontakt hergestellt ist. Das Federelement dient in dieser Ausgestaltung also nicht nur der mechanischen Fixierung der Aktoreinheit in der Aussparung der Trägerplatte, sondern stellt durch die Federwirkung auch eine zuverlässige elektrische Kontaktierung her, weil Toleranzen, welche z.B. durch Wärmeausdehnung und Fertigung vorliegen, ausgeglichen werden.

Gemäß der Erfindung weist die Backplane zwei oder mehr Aktoreinheiten auf, welche in mehreren Lagen in bzw. an der Trägerplatte angeordnet sind. Eine in Bezug auf die Ebene der Trägerplatte mehrlagige Anordnung der Aktoreinheiten bietet den Vorteil, dass Durchkontaktierungen, d. h. vertikale elektrische Verbindungen zwischen Leiterbahnebenen der Trägerplatte, einfacher herzustellen sind. Somit lassen sich komplexe Schaltungen der Backplane entflechten.

Gemäß einer bevorzugten Ausgestaltung der Erfindung werden die Leiterbahnen mit einem additiven Fertigungsverfahren, beispielsweise mit einem 3D-Druck, aus einer elektrisch leitfähigen Paste gedruckt, die nach dem Auftragen auf die Trägerplatte und/oder die zwei oder mehr Aktoreinheiten gehärtet wird. Die Trägerplatte und das Leitungsnetz werden mit einem additiven Fertigungsverfahren, beispielsweise mit einem 3D-Druck, gefertigt. Die Leiterbahnen werden dabei aus einer elektrisch leitfähigen Paste, insbesondere aus einer Kupfer-, Aluminium-, Messing- oder Silberpaste, gedruckt. Die vorgenannte Ausgestaltung der Erfindung berücksichtigt, dass unterschiedliche Konfigurationen elektrisch zu verbindender Bauelemente auch unterschiedliche Querschnitte und Verläufe der Leiterbahnen erfordern.

Beim Verdrahten eines elektromagnetischen Schaltgeräts werden verschiedene Leiter an das Schaltgerät angeschlossen. Die anzuschließenden Leiter umfassen zumindest die Hauptleiter, welche mittels des Schaltgeräts geschaltet werden. Weiterhin werden in vielen Fällen Hilfsleiter angeschlossen, welche den Schaltzustand des Schaltgeräts an eine übergeordnete Steuerung rückmelden. Weiterhin werden in vielen Fällen Steuerleiter zur Betätigung des Schaltgerätes angeschlossen.

Beispielsweise sind für leistungsführende Hauptleiter dickere Leiterbahnen als für Steuer- und Hilfsleiter erforderlich, und unterschiedliche Anordnungen der Bauelemente erfordern unterschiedliche Verläufe der Leiterbahnen. Die Fertigung der Leiterbahnen mit einem 3D-Druck ermöglicht, die Querschnitte und die Verläufe der Leiterbahnen in einfacher Weise flexibel der Konfiguration der jeweils elektrisch zu verbindenden Bauelemente anzupassen. Insbesondere ermöglicht dies eine kostengünstige Serienfertigung von Backplanes für unterschiedliche Konfigurationen elektrischer Bauelemente. Ein 3D-Druck der Leiterbahnen aus einer elektrisch leitfähigen, aushärtbaren Paste ist vorteilhaft, da sich eine Paste in einfacher Weise aufbringen lässt und nach dem Aufbringen nicht verläuft und durch Aushärten stabilisiert werden kann. Kupferpasten, Aluminiumpasten, Messingpasten und Silberpasten eignen sich aufgrund ihrer guten elektrischen Leitfähigkeit besonders gut als Material für den 3D-Druck der Leiterbahnen.

Gemäß einer bevorzugten Ausgestaltung der Erfindung wird wenigstens eine Kontaktfläche der zwei oder mehr Aktoreinheiten nach deren Integration in die Trägerplatte mit einer elektrisch leitfähigen Paste zur Ausbildung von Leiterbahnen bedruckt. Dabei kann die Paste als ein insbesondere niedrigschmelzendes Lot ausgebildet sein, so dass durch eine nach dem Druckvorgang durchgeführte Erwärmung in einem Lötverfahren ein Schmelzen des Lots hervorgerufen und nach einem nachfolgenden Abkühlen eine gelötete Verbindung zwischen einer gedruckten Leiterbahn und der wenigstens einen Kontaktfläche erzeugt wird. Alternative Verfahren zum Verbinden der Leiterbahnen mit den Kontaktflächen sind Löten mithilfe eines Laserstrahls, Sintern und Vibrationsschweißen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den schematischen Zeichnungen näher erläutert werden. Dabei zeigen:
- Fig. 1: einen Schnitt einer Backplane mit einer eingebetteten Aktoreinheit;
- Fig. 2: einen Schnitt einer weiteren Backplane mit einer eingebetteten Aktoreinheit;
- Fig. 3: einen Einsetzvorgang einer Aktoreinheit in eine Ausnehmung einer Trägerplatte im Schnitt;
- Fig. 4: einen Zustand nach dem in Fig. 3 dargestellten Einsetzvorgang;
- Fig. 5: einen Schnitt einer Backplane mit mehrlagig angeordneten Aktoreinheiten;
- Fig. 6: einen Schnitt einer Backplane mit einer eingesetzten Aktoreinheit mit Federelementen;
- Fig. 7: einen Schnitt einer Backplane mit einer auf eine Trägerplatte aufgesetzten Aktoreinheit;
- Fig. 8: einen Schnitt einer Backplane mit einer in eine Ausnehmung einer Trägerplatte eingesetzten Aktoreinheit;
- Fig. 9: einen Schnitt einer Backplane mit einer durch ein Abschirmelement abgeschirmten Aktoreinheit;
- Fig. 10: einen Schnitt einer Backplane mit einer durch ein Kühlelement gekühlten Aktoreinheit;
- Fig. 11: eine Backplane;
- Fig. 12: eine perspektivische Darstellung eines Schaltschranks; und
- Fig. 13 bis 15: Schnitte weiterer Backplanes mit einer eingesetzten Aktoreinheit mit Federelementen.

Einander entsprechende Teile sind in den Figuren mit denselben Bezugszeichen versehen.

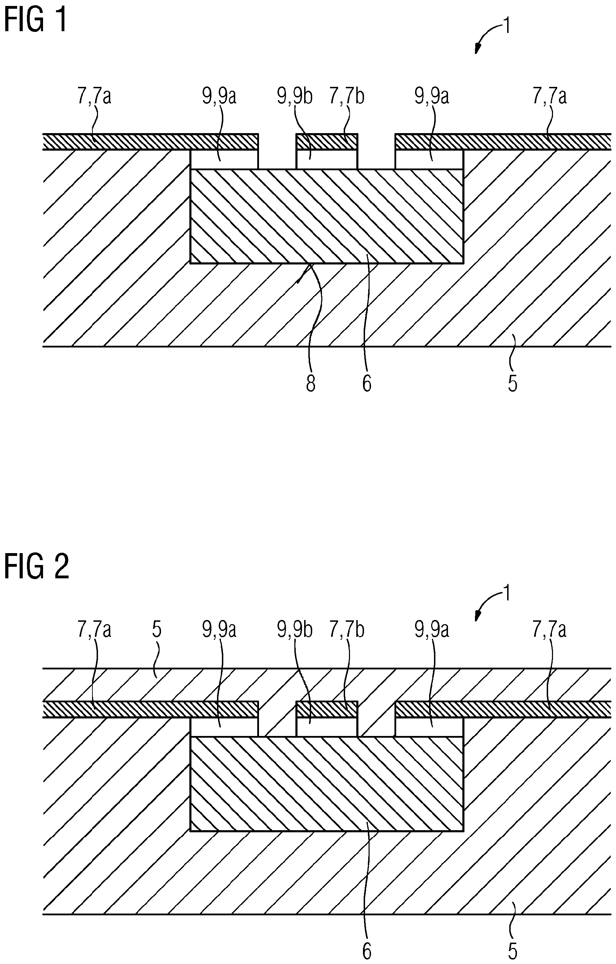

Fig. 1 zeigt einen Schnitt einer Backplane 1, welche zum elektrischen Verbinden elektrischer Bauelemente dient. Die Backplane 1 weist eine durch ein AM-Verfahren, hier: einen 3D-Druck, hergestellte Trägerplatte 5, z. B. aus einem elektrisch nicht-leitenden organischen Material wie Kunststoff, auf. Die Backplane 1 weist außerdem eine in die Trägerplatte 5 eingebettete Aktoreinheit 6, z. B. ein Schaltgerät wie ein Halbleiter-Schalter oder ein MEMS-Schalter, auf. Die Aktoreinheit 6 weist an seiner Oberseite elektrische Kontakte 9, 9a, 9b auf. Die Backplane 1 weist außerdem Leiterbahnen 7, 7a, 7b auf, die jeweils aus einer elektrisch leitfähigen Paste gedruckt sind und auf der Trägerplatte 5 verlaufen. Die Leiterbahnen 7, 7a, 7b unterscheiden sich: zwei Leiterbahnen 7a mit größerem Querschnitt dienen als Hauptleiter zum Übertragen größerer Leistungen und Stromstärken, eine Leiterbahn 7b mit kleinerem Querschnitt dient als Steuerleiter 7a zum Übertragen von Steuersignalen mit geringen Stromstärken. Die beiden Hauptleiter 7a sind jeweils mit einem Hauptkontakt 9a verbunden, der Steuerleiter 7b ist mit einem Steuerkontakt 9b verbunden; durch ein über den Steuerleiter 7b an den Steuerkontakt 9b der Aktoreinheit 6 übertragenes Steuersignal kann die Aktoreinheit 6 so angesteuert werden, dass die Aktoreinheit 6 eine elektrische Verbindung zwischen den beiden Hauptleitern 7a herstellt.

Die Aktoreinheit 6 wird während eines schichtweisen 3D-Drucks der Trägerplatte 5 mit ihrer den Kontaktflächen 9 gegenüber liegenden Oberfläche 8 auf die zu diesem Zeitpunkt existierende Oberfläche der Trägerplatte 5 aufgesetzt, z. B. durch einen Roboter, und durch den fortgesetzten, bis an die Aktoreinheit 6 heran reichenden 3D-Druck in das 3D-Druck-Material eingebettet. Wenn das aufgebrachte 3D-Druck-Material das Niveau der Kontaktflächen 9 erreicht hat, werden die Leiterbahnen 7 auf die Oberfläche der fertig gestellten Trägerplatte 5 sowie die Kontaktflächen 9 aufgedruckt.

Dabei werden die Leiterbahnen 7 zumindest im Bereich der Kontaktflächen 9 in Form einer Lotpaste auf die Oberfläche der Trägerplatte 5 und jeweils zumindest einen Teilbereich der Kontaktflächen 9 aufgedruckt, so dass durch eine dem Druckvorgang folgende Erwärmung in einem Reflow-Lötverfahren ein Schmelzen der Lotpaste hervorgerufen und nach einem nachfolgenden Abkühlen eine gelötete elektrische Verbindung zwischen den Leiterbahnen 7 und den Kontaktflächen 9 vorliegt.

Fig. 2 zweigt einen Schnitt einer weiteren Backplane 1 mit einer eingebetteten Aktoreinheit 6. Die obigen Erläuterungen zu Fig. 1 gelten bei diesem Ausführungsbeispiel entsprechend. Zusätzlich zu der in Fig. 1 dargestellten Backplane 1 ist bei der in Fig. 2 dargestellten Backplane 1 nach dem Drucken der Leiterbahnen 7 und dem elektrischen Verbinden der Leiterbahnen 7 und der Kontaktflächen 9 eine zusätzliche Schicht des die Trägerplatte 5 bildenden 3D-Druck-Materials auf die Leiterbahnen 7 und die Aktoreinheit 6 aufgedruckt worden, so dass die Leiterbahnen 7 und die Aktoreinheit 6 vollständig in die Trägerplatte 5 eingebettet sind.

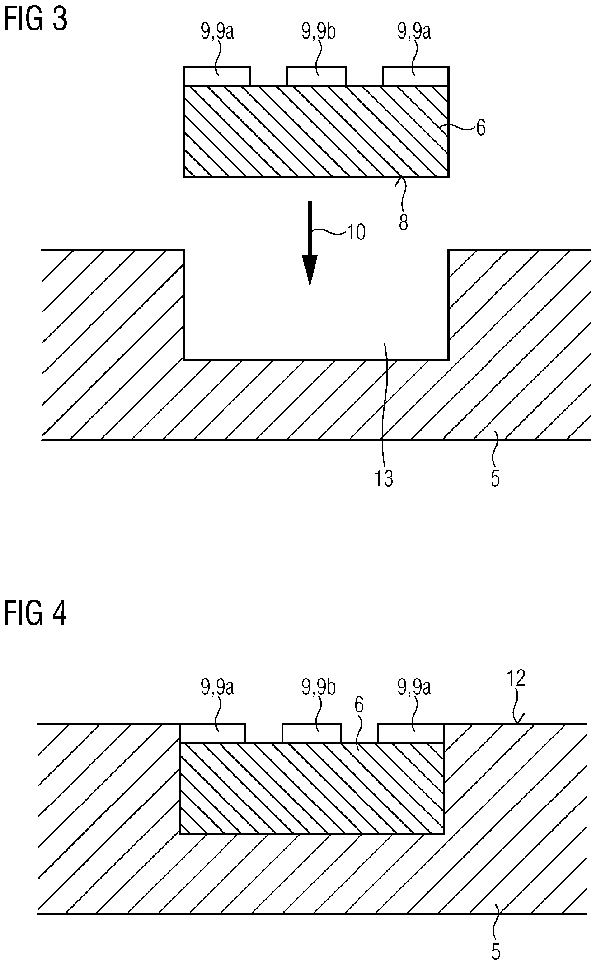

Fig. 3 zeigt eine Einsetzbewegung 10 einer Aktoreinheit 6 in eine Ausnehmung 13 einer Trägerplatte 5 im Schnitt. In einem ersten Schritt wird eine Trägerplatte 5 durch ein AM-Verfahren, hier: einen 3D-Druck, hergestellt. Dabei wird ein Volumen des Druckbereichs frei von 3D-Druck-Material gehalten, so dass sich in der Trägerplatte 5 eine Ausnehmung 13 bildet, deren Abmessungen den Außenmaßen einer in die Trägerplatte 5 zu integrierenden Aktoreinheit 6 entsprechen. In einem zweiten Schritt wird die in die Trägerplatte 5 zu integrierende Aktoreinheit 6 mit ihrer den Kontaktflächen 9 gegenüber liegenden Oberfläche 8 voran in die Ausnehmung 13 der Trägerplatte 5 eingesetzt, vorzugsweise, entsprechend einer automatisierten Herstellung der Backplane, durch einen Roboter.

Fig. 4 zeigt einen Zustand nach dem in Fig. 3 dargestellten Einsetzvorgang. Die Kontaktflächen 9 der Aktoreinheit 6 sind bezüglich eines Höhenniveaus niveaugleich mit der Oberfläche 12 der Trägerplatte 5. In einem nachfolgenden Schritt können Leiterbahnen 7 auf die Oberfläche der Trägerplatte 5 und der Kontaktflächen 9 aufgedruckt werden, um eine elektrische Kontaktierung der Aktoreinheit 6 herzustellen.

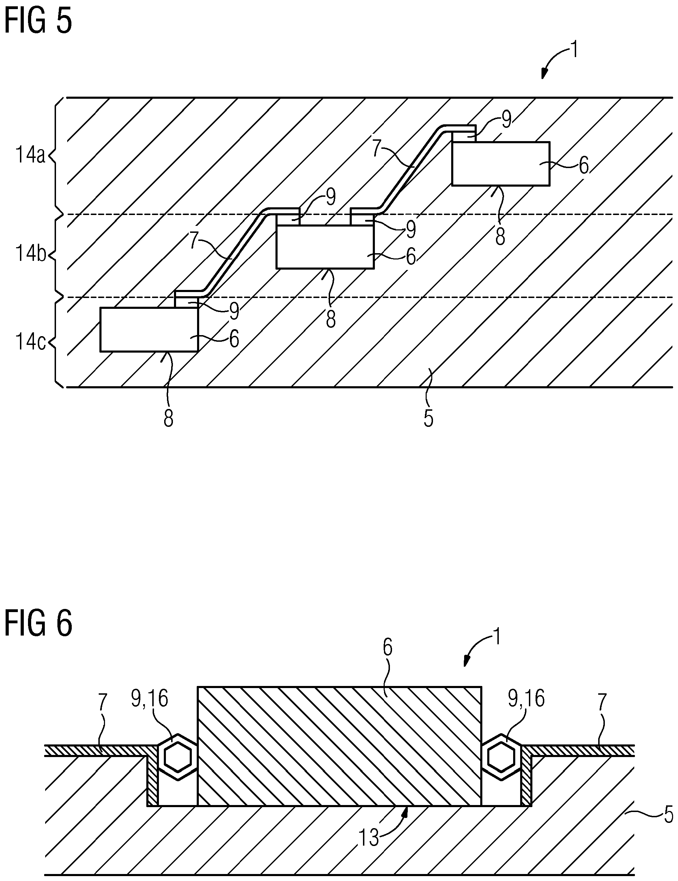

Fig. 5 zeigt einen Schnitt einer Backplane 1 mit mehrlagig angeordneten Aktoreinheiten 6. Die Backplane weist drei in der Ebene der Trägerplatte 5 verlaufende Lagen 14a, 14b, 14c auf. In jeder der Lagen 14a, 14b, 14c ist eine Aktoreinheit 6 angeordnet. Dabei werden die Aktoreinheiten 6 während eines 3D-Drucks der Trägerplatte 5 nacheinander in die bis dahin fertiggestellte der Trägerplatte 5 eingesetzt und beim Fortsetzen des 3D-Drucks durch das 3D-Druck-Material der Trägerplatte 5 umschlossen. Ebenfalls während des 3D-Drucks der Trägerplatte 5 werden Kontaktflächen 9 der Aktoreinheiten 6 miteinander verbindende Leiterbahnen 7 durch den 3D-Druck gedruckt.

Fig. 6 zeigt einen Schnitt einer Backplane 1 mit einer in eine Aussparung 13 einer Trägerplatte 5 eingesetzten Aktoreinheit 6 mit als Metallfedern ausgebildeten Federelementen 16. Die Federelemente 16 dienen einerseits der mechanischen Fixierung der Aktoreinheit 6 in der Aussparung 13 der Trägerplatte 5. Die Federelemente 16 dienen andererseits aufgrund ihrer elektrischen Leitfähigkeit auch einer elektrischen Verbindung zwischen Kontaktflächen der Aktoreinheit 6 und in die Trägerplatte 5 integrierten Leiterbahnen 7. Dazu weisen die Federelemente 16 elektrische Kontaktflächen 9 der Aktoreinheit 6 auf. Durch die Federkraft der Federelemente 16 wird eine an dem Federelement 16 angeordnete Kontaktfläche 9 der Aktoreinheit 6 an eine in die Trägerplatte 5 integrierte Leiterbahn 7 angepresst, so dass ein zuverlässiger elektrischer Kontakt hergestellt ist. Es ist auch möglich, dass das Federelement ein mittels 3D-Druck zusammen mit der Trägerplatte 5 hergestelltes und an der Trägerplatte 5 angeordnetes Element ist. Bei dieser Ausgestaltung kann das Aktorelement 6 nachträglich der Trägerplatte 5 wieder entnommen werden, z.B. zum Auswechseln der Aktoreinheit 6. Dazu kann das Aktorelement 6 zerstörungsfrei einfach nach oben herausgezogen werden.

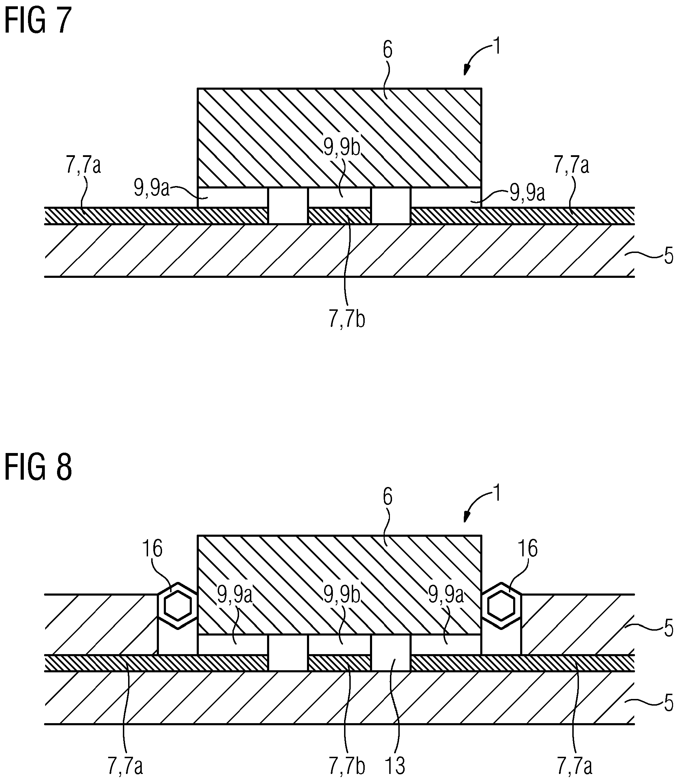

Fig. 7 zeigt einen Schnitt einer Backplane 1 mit einer auf eine Trägerplatte 5 aufgesetzten Aktoreinheit 6. Die Aktoreinheit 6 wird im Anschluss an einen schichtweisen 3D-Druck der Trägerplatte 5 mit ihren Kontaktflächen 9 auf die Leiterbahnen 7 bzw. auf an die Leiterbahnen 7 angefügte Kontaktierungsplättchen der Trägerplatte 5 aufgesetzt, z. B. durch einen Roboter. In einem nachfolgenden Verbindungsverfahren, z. B. Lötverfahren, Löten mithilfe eines Laserstrahls, Sintern und Vibrationsschweißen, können die Kontaktflächen 9 mit den Leiterbahnen 7 bzw. mit den an die Leiterbahnen 7 angefügte Kontaktierungsplättchen der Trägerplatte 5 elektrisch verbunden werden.

Fig. 8 zeigt einen Schnitt einer weiteren Backplane 1 mit einer in eine Ausnehmung 13 einer Trägerplatte 5 eingesetzten Aktoreinheit 6. Die obigen Erläuterungen zu Fig. 7 gelten bei diesem Ausführungsbeispiel entsprechend. Zusätzlich zu der in Fig. 7 dargestellten Backplane 1 ist bei der in Fig. 8 dargestellten Backplane 1 nach dem Drucken der Leiterbahnen 7 und dem elektrischen Verbinden der Leiterbahnen 7 bzw. der an die Leiterbahnen 7 angefügte Kontaktierungsplättchen und der Kontaktflächen 9 eine zusätzliche Schicht des die Trägerplatte 5 bildenden 3D-Druck-Materials auf die Leiterbahnen 7 und die Aktoreinheit 6 aufgedruckt worden. Es ist dabei eine Ausnehmung 13 der Trägerplatte 5 hergestellt worden, in der die Aktoreinheit 6 mithilfe von Federelementen 16, die an Seitenflächen der Aktoreinheit 6 angeordnet sind, mechanisch fixiert ist.

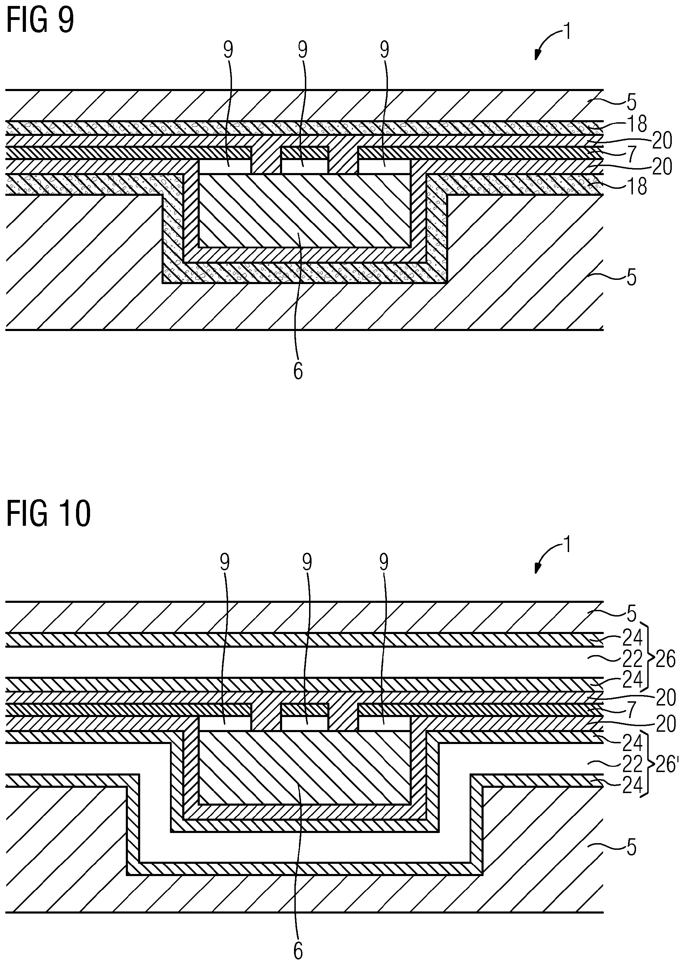

Fig. 9 zeigt einen Schnitt einer Backplane 1 mit einer in eine Trägerplatte 5 eingebetteten Aktoreinheit 6, deren Kontaktflächen 9 mit ebenfalls in die Trägerplatte 5 eingebetteten Leiterbahnen 7 elektrisch verbunden sind. Die Backplane 1 weist außerdem ein zum Abschirmen elektrischer und/oder magnetischer Felder geeignetes Abschirmelement 18 auf. Dabei umschließt das Abschirmelement 18 die Aktoreinheit 6 und die Leiterbahnen 7.

Das Abschirmelement 18 ist röhrenartig ausgebildet und ummantelt die Aktoreinheit 6 und die elektrische Leiterbahn 7, wobei ihre Innenoberfläche von der Aktoreinheit 6 und der elektrischen Leiterbahn 7 beabstandet ist. Das Abschirmelement 18 ist aus einem elektrisch leitfähigen Material gefertigt und schirmt die Aktoreinheit 6 und die elektrische Leiterbahn 7 elektrisch ab. Alternativ oder zusätzlich kann das Abschirmelement 18 zur magnetischen Abschirmung der Aktoreinheit 6 und der elektrischen Leiterbahn 7 ausgebildet sein und dazu eine ausreichende magnetische Permeabilität aufweisen. Beispielsweise ist das Abschirmelement 18 aus Graphen oder aus Kohlenstoffnanoröhren oder aus einem mit Kohlenstoffnanoröhren gefüllten Kunststoff gefertigt.

Die Aktoreinheit 6 und die elektrische Leiterbahn 7 ist von einem elektrisch isolierenden Isolationsmaterial 20 umhüllt, das einen Zwischenraum zwischen der Aktoreinheit 6 bzw. der elektrischen Leiterbahn 7 und dem Abschirmelement 18 ausfüllt. Das Isolationsmaterial 20 ist beispielsweise ein Isolierlack oder ein Kunststoff und isoliert die Aktoreinheit 6 und die elektrische Leiterbahn 7 von dem Abschirmelement 18.

Fig. 10 zeigt einen Schnitt einer Backplane 1 mit einer in eine Trägerplatte 5 eingebetteten Aktoreinheit 6, deren Kontaktflächen 9 mit ebenfalls in die Trägerplatte 5 eingebetteten Leiterbahnen 7 elektrisch verbunden sind. Die Backplane 1 weist außerdem zum Kühlen geeignete, jeweils als Kühlkanal ausgebildete Kühlelemente 26, 26' auf. Jeder der Kühlkanäle 26, 26' weist einen von einer schlauchförmigen Kanalwand 22 umschlossenen Hohlraum 24 auf.

Die Aktoreinheit 6 und die Leiterbahnen 7 sind mit einer Isolationsschicht 20 beschichtet. An der Isolationsschicht 20 sind die zwei Kühlkanäle 26, 26' angeordnet, die parallel zu der Aktoreinheit 6 und den Leiterbahnen 7 in der Trägerplatte 3 verlaufen und zum Leiten eines Kühlfluids in dem Hohlraum 24 ausgebildet sind. Das Kühlfluid ist eine Kühlflüssigkeit, beispielsweise Kühlwasser, oder ein Kühlgas, beispielsweise Luft. Die Endbereiche der Kühlkanäle 26, 26' können jeweils einen Kühlfluidanschluss aufweisen. Dabei können auch beide Kühlkanäle 26, 26' einen gemeinsamen Kühlfluidanschluss aufweisen. Alternativ kann nur ein Endbereich jedes Kühlkanals 26, 26' einen Kühlfluidanschluss aufweisen und die anderen Endbereiche der Kühlkanäle 26, 26' können miteinander verbunden sein, so dass die Kühlkanäle 26, 26' einen Kühlfluidkreislauf bilden, in dem ein erster Kühlkanal 26 in einer ersten Strömungsrichtung und der andere Kühlkanal 26' in einer der ersten Strömungsrichtung entgegengesetzten zweiten Strömungsrichtung von dem Kühlfluid durchströmt wird.

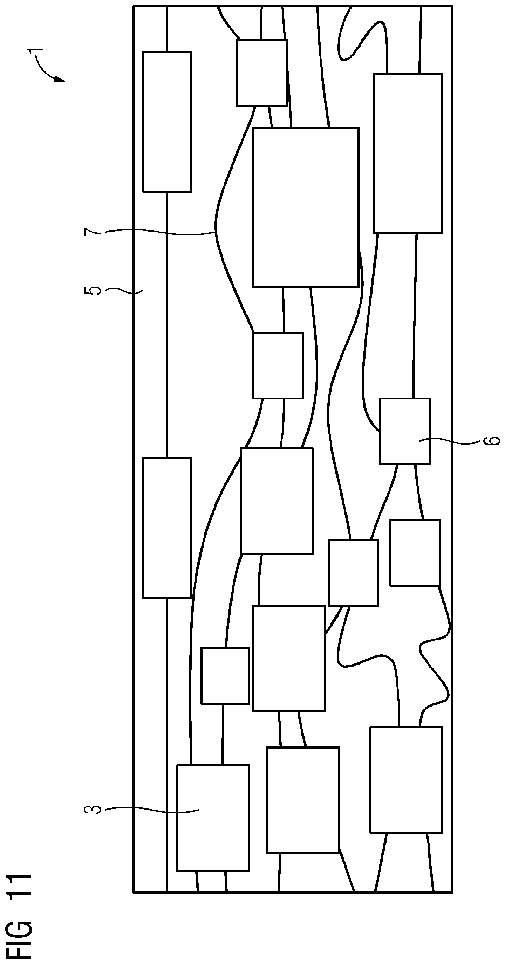

Fig. 11 zeigt eine schematische Darstellung einer Backplane 1 in einer Draufsicht auf die Backplane 1. Auf der Backplane 1 sind mehrere elektrische Bauelemente 3 angeordnet.

Ein elektrisches Bauelement 3 kann beispielsweise ein Schütz, ein Schalter, eine Steuereinheit, eine Eingabe-/ Ausgabeeinheit, ein Sanftstarter oder ein Frequenzumrichter sein.

Die Backplane 1 weist eine Trägerplatte 5, auf der Trägerplatte 5 angeordnete Leiterbahnen 7 und in die Trägerplatte 5 integrierte Aktoreinheiten 6 auf.

Die Leiterbahnen 7 verbinden jeweils elektrische Bauelemente 3 und/oder Aktoreinheiten 6 elektrisch miteinander.

Bei der Herstellung der Backplane 1 werden die Aktoreinheiten 6 durch ein additives Fertigungsverfahren in die Trägerplatte 5 integriert. Beispielsweise wird die Trägerplatte 5 wenigstens in jedem eine Aktoreinheit 6 umgebenden Bereich mit einem 3D-Druck hergestellt, der die jeweilige Aktoreinheit 6 in die Trägerplatte 5 einbettet.

Ferner werden bei der Herstellung der Backplane 1 die Leiterbahnen 7 beispielsweise mit einem 3D-Druck auf die Trägerplatte 5 aufgebracht. Beispielsweise werden die Leiterbahnen 7 aus einer elektrisch leitfähigen Paste, insbesondere aus einer Kupferpaste, Aluminiumpaste, Messingpaste oder Silberpaste, gedruckt, die nach dem Auftragen auf die Trägerplatte 5 gehärtet wird.

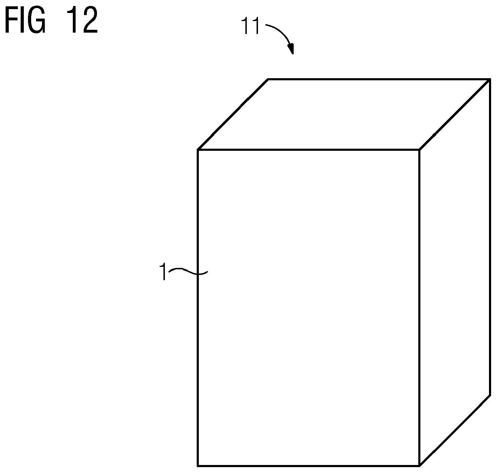

Fig. 12 zeigt eine perspektivische Darstellung eines Schaltschranks 11. Der Schaltschrank 11 weist eine anhand der Figur 11 beschriebene Backplane 1 auf, die eine Rückwand des Schaltschranks 11 bildet.

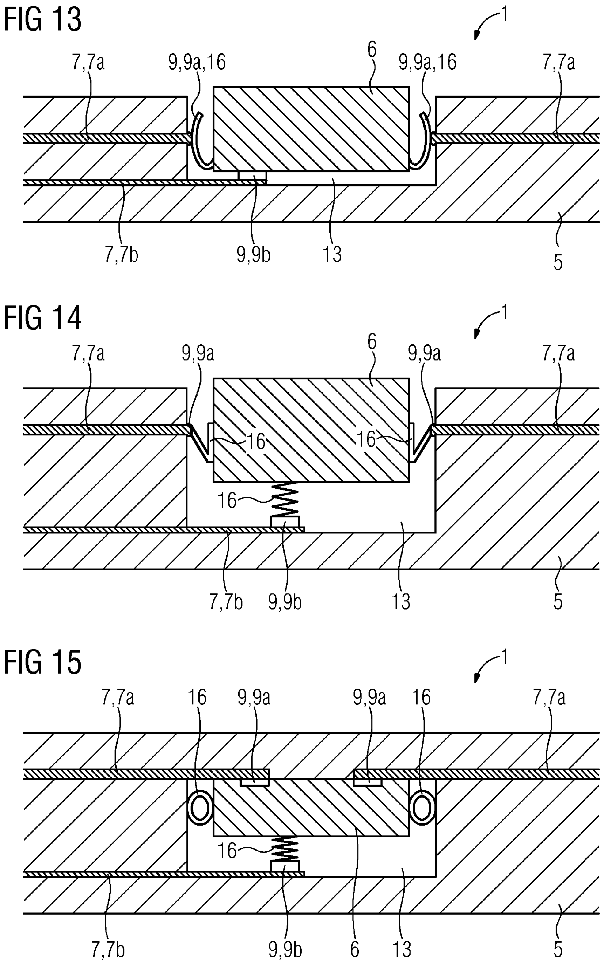

Fig. 13 zeigt einen Schnitt einer weiteren Backplane 1 mit einer in eine Ausnehmung 13 einer Trägerplatte 5 eingesetzten Aktoreinheit 6 mit als Metallfedern ausgebildeten Federelementen 16 an den Seitenwänden. Die Federelemente 16 dienen einerseits der mechanischen Fixierung der Aktoreinheit 6 in der Aussparung 13 der Trägerplatte 5. Die Federelemente 16 dienen andererseits aufgrund ihrer elektrischen Leitfähigkeit auch einer elektrischen Verbindung zwischen Kontaktflächen der Aktoreinheit 6 und in die Trägerplatte 5 integrierten Hauptleiterbahnen 7, 7a. Dazu weisen die Federelemente 16 elektrische Kontaktflächen 9, 9a der Aktoreinheit 6 auf. Durch die Federkraft der Federelemente 16 wird eine an dem Federelement 16 angeordnete Kontaktfläche 9, 9a der Aktoreinheit 6 an eine in die Trägerplatte 5 integrierte Hauptleiterbahn 7, 7a angepresst, so dass ein zuverlässiger elektrischer Kontakt hergestellt ist. Die Aktoreinheit 6 wird beim Einsetzen in die Ausnehmung 13 mit einer an der Unterseite angeordneten Kontaktfläche 9, 9b auf eine Steuerleiterbahn 7. 7b der Trägerplatte 5 aufgesetzt, z.B. durch einen Roboter.

Bei dieser Ausgestaltung kann das Aktorelement 6 nachträglich der Trägerplatte 5 wieder entnommen werden, z. B. zum Auswechseln der Aktoreinheit 6. Dazu kann das Aktorelement 6 zerstörungsfrei einfach nach oben herausgezogen werden.

Fig. 14 zeigt einen Schnitt einer weiteren Backplane 1 mit einer in eine Ausnehmung 13 einer Trägerplatte 5 eingesetzten Aktoreinheit 6 mit als Metallfedern ausgebildeten Federelementen 16 an den Seitenwänden und der Unterseite. Die Federelemente 16 dienen einerseits der mechanischen Fixierung der Aktoreinheit 6 in der Aussparung 13 der Trägerplatte 5. Die Federelemente 16 dienen andererseits aufgrund ihrer elektrischen Leitfähigkeit auch einer elektrischen Verbindung zwischen Kontaktflächen der Aktoreinheit 6 und in die Trägerplatte 5 integrierten Hauptleiterbahnen 7, 7a und Steuerleiterbahnen 7, 7b. Dazu weisen die Federelemente 16 elektrische Kontaktflächen 9, 9a, 9b der Aktoreinheit 6 auf. Durch die Federkraft der Federelemente 16 wird eine an dem Federelement 16 angeordnete Kontaktfläche 9, 9a, 9b der Aktoreinheit 6 an eine in die Trägerplatte 5 integrierte Hauptleiterbahn 7, 7a bzw. Steuerleiterbahn 7, 7b angepresst, so dass ein zuverlässiger elektrischer Kontakt hergestellt ist. Die Aktoreinheit 6 wird beim Einsetzen in die Ausnehmung 13 mit einer an der Unterseite angeordneten Kontaktfläche 9, 9b auf eine Steuerleiterbahn 7b der Trägerplatte 5 aufgesetzt, z. B. durch einen Roboter.

Bei dieser Ausgestaltung kann das Aktorelement 6 nachträglich der Trägerplatte 5 wieder entnommen werden, z. B. zum Auswechseln der Aktoreinheit 6. Dazu kann das Aktorelement 6 zerstörungsfrei einfach nach oben herausgezogen werden.

Fig. 15 zeigt einen Schnitt einer weiteren Backplane 1 mit einer in eine Ausnehmung 13 einer Trägerplatte 5 eingesetzten Aktoreinheit 6 mit als Metallfedern ausgebildeten Federelementen 16 an den Seitenwänden und der Unterseite. Die an den Seitenwänden angeordneten Federelemente 16 dienen ausschließlich der mechanischen Fixierung der Aktoreinheit 6 in der Aussparung 13 der Trägerplatte 5.

Das an der Unterseite angeordnete metallische Federelement 16 dient einerseits der mechanischen Fixierung der Aktoreinheit 6 in der Aussparung 13 der Trägerplatte 5, andererseits aufgrund seiner elektrischen Leitfähigkeit auch einer elektrischen Verbindung zwischen Kontaktflächen der Aktoreinheit 6 und in die Trägerplatte 5 integrierten Steuerleiterbahnen 7, 7b. Dazu weist das an der Unterseite angeordnete metallische Federelement 16 elektrische Kontaktflächen 9, 9b der Aktoreinheit 6 auf. Durch die Federkraft des an der Unterseite angeordnete Federelement 16 wird eine an dem Federelement 16 angeordnete Kontaktfläche 9, 9b der Aktoreinheit 6 an eine in die Trägerplatte 5 integrierte Steuerleiterbahn 7, 7b angepresst, so dass ein zuverlässiger elektrischer Kontakt hergestellt ist.

Die Aktoreinheit 6 wird beim Einsetzen in die Ausnehmung 13 mit einer an der Unterseite angeordneten Kontaktfläche 9, 9b auf eine Steuerleiterbahn 7b der Trägerplatte 5 aufgesetzt, z. B. durch einen Roboter.

Nach dem Einsetzen der Aktoreinheit 6 in die Ausnehmung 13 werden Hauptleiterbahnen 7, 7a und eine zusätzliche Schicht des die Trägerplatte 5 bildenden 3D-Druck-Materials auf die Hauptleiterbahnen 7, 7a und die Aktoreinheit 6 aufgedruckt, so dass die Leiterbahnen 7, 7a und die Aktoreinheit 6 vollständig in die Trägerplatte 5 eingebettet sind. Dabei kontaktieren die aufgedruckten Hauptleiterbahnen 7, 7a an der Oberseite der Aktoreinheit 6 angeordnete Hauptkontaktflächen 9, 9a.

## Patentansprüche

1. Backplane (1) zum elektrischen Verbinden elektrischer Bauelemente (3), die Backplane (1) umfassend
- eine Trägerplatte (5),
- Leiterbahnen (7), die jeweils auf und/oder in der Trägerplatte (5) verlaufen, und
- zwei oder mehr auf oder in der Trägerplatte (5) angeordnete Aktoreinheiten (6),
**gekennzeichnet dadurch,**
**dass** zwei oder mehr Aktoreinheiten (6) in mehreren Lagen (14a, 14b, 14c) in bzw. an der Trägerplatte (5) angeordnet sind , die wenigstens in einem die zwei oder mehr Aktoreinheiten (6) umgebenden Bereich zur Einbettung dieser Aktoreinheiten mit einem 3D-Druck hergestellt wurde.

2. Backplane (1) nach Anspruch 1,
wobei wenigstens eine Aktoreinheit (6) als eine bestückte Leiterplatte ausgebildet ist.

3. Backplane (1) nach einem der vorhergehenden Ansprüche, wobei wenigstens eine Aktoreinheit (6) als ein Mikrosystem, insbesondere als ein MEMS, ausgebildet ist.

4. Backplane (1) nach einem der vorhergehenden Ansprüche, **gekennzeichnet durch** wenigstens ein an den zwei oder mehr Aktoreinheiten (6) angeordnetes Abschirmelement (18) zum Abschirmen elektrischer und/oder magnetischer Felder.

5. Backplane (1) nach einem der vorhergehenden Ansprüche, **gekennzeichnet durch** wenigstens ein an den zwei oder mehr Aktoreinheiten (6) angeordnetes Kühlelement (26) zur Kühlung der Aktoreinheit (6).

6. Backplane (1) nach einem der vorhergehenden Ansprüche, wobei die zwei oder mehr Aktoreinheiten (6) herausnehmbar in eine Aussparung (13) der Trägerplatte (5) eingesetzt ist.

7. Backplane (1) nach Anspruch 6, wobei die zwei oder mehr Aktoreinheiten (6) mithilfe von Federelementen (16), insbesondere elektrisch leitfähigen Federelementen (16), in der Aussparung (13) der Trägerplatte (5) fixiert ist.

8. Schaltschrank (11) mit einer gemäß einem der vorhergehenden Ansprüche ausgebildeten Backplane (1).

9. Verfahren zur Herstellung einer gemäß einem der Ansprüche 1 bis 7 ausgebildeten Backplane (1), wobei die zwei oder mehr in mehreren Lagen in oder auf der Trägerplatte (5) anzuordnenden Aktoreinheiten (6) durch einen 3D-Druck in die Trägerplatte (5) integriert werden.

10. Verfahren nach Anspruch 9, **dadurch gekennzeichnet, dass** die zwei oder mehr Aktoreinheiten (6) in die Trägerplatte (5) integriert werden, indem die Trägerplatte (5) wenigstens in einem die zwei oder mehr Aktoreinheiten (6) umgebenden Bereich mit einem 3D-Druck hergestellt wird, der die Aktoreinheit (6) in die Trägerplatte (5) einbettet.

11. Verfahren nach Anspruch 9. **dadurch gekennzeichnet, dass** die zwei oder mehr Aktoreinheiten (6) in die Trägerplatte (5) integriert werden, indem in der Trägerplatte (5) eine Aussparung (13) vorgesehen wird, worin die zwei oder mehr Aktoreinheiten (6) eingesetzt werden.

12. Verfahren nach einem der Ansprüche 9 bis 11, **dadurch gekennzeichnet, dass** die Leiterbahnen (7) mit einem 3D-Druck aus einer elektrisch leitfähigen Paste gedruckt werden, die nach dem Auftragen auf die Trägerplatte (5) und/oder die zwei oder mehr Aktoreinheiten (6) gehärtet wird.

13. Verfahren nach einem der Ansprüche 9 bis 12, **dadurch gekennzeichnet, dass** wenigstens eine Kontaktfläche (9, 9a, 9b, 9c) der zwei oder mehr Aktoreinheiten (6) nach deren Integration in die Trägerplatte (5) mit einer elektrisch leitfähigen Paste zur Ausbildung von Leiterbahnen (7) bedruckt wird.

## Claims

1. Backplane (1) for electrically connecting electrical components (3), the backplane (1) comprising
- a carrier plate (5),
- conductor paths (7), which in each case run on and/or in the carrier plate (5), and
- two or more actuator units (6) arranged on or in the carrier plate (5),
**characterised in that**
two or more actuator units (6) are arranged in a plurality of layers (14a, 14b, 14c) in or on the carrier plate (5) which, at least in a region surrounding the two or more actuator units (6) for the embedding of said actuator units (6), was produced using a 3D printing.

2. Backplane (1) according to claim 1,
wherein at least one actuator unit (6) is embodied as a populated printed circuit board.

3. Backplane (1) according to one of the preceding claims, wherein at least one actuator unit (6) is embodied as a microsystem, in particular as a MEMS.

4. Backplane (1) according to one of the preceding claims, **characterised by** at least one shielding element (18) arranged on the at least two or more actuator units (6) for shielding from electrical and/or magnetic fields.

5. Backplane (1) according to one of the preceding claims, **characterised by** at least one cooling element (26) arranged on the two or more actuator units (6) for cooling the actuator unit (6).

6. Backplane (1) according to one of the preceding claims, wherein the two or more actuator units (6) is inserted into a recess (13) of the carrier plate (5) in a removable manner.

7. Backplane (1) according to claim 6,
wherein the two or more actuator units (6) is fixed in the recess (13) of the carrier plate (5) with the aid of spring elements (16), in particular electrically conductive spring elements (16).

8. Switchgear cabinet (11) with a backplane (1) embodied according to one of the preceding claims.

9. Method for producing a backplane (1) embodied according to one of claims 1 to 7, wherein the two or more actuator units (6) to be arranged in a plurality of layers in or on the carrier plate (5) are integrated into the carrier plate (5) by way of a 3D printing.

10. Method according to claim 9,
**characterised in that** the two or more actuator units (6) are integrated into the carrier plate (5) by the carrier plate (5) being produced, at least in a region surrounding the two or more actuator units (6), using a 3D printing which embeds the actuator unit (6) into the carrier plate (5).

11. Method according to claim 9,
**characterised in that** the two or more actuator units (6) are integrated into the carrier plate (5) by a recess (13) being provided in the carrier plate (5), into which the two or more actuator units (6) are inserted.

12. Method according to one of claims 9 to 11,
**characterised in that** the conductor paths (7) are printed using a 3D printing from an electrically conductive paste, which is cured after being applied to the carrier plate (5) and/or the two or more actuator units (6).

13. Method according to one of claims 9 to 12,
**characterised in that** at least one contact area (9, 9a, 9b, 9c) of the two or more actuator units (6), after the integration thereof into the carrier plate (5), is printed with an electrically conductive paste to form conductor paths (7) .

## Revendications

1. Fond de panier (1) de connexion électrique de composants (3) électriques, le fond de panier (1) comprenant :
- une plaque (5) formant support,
- des pistes (7) conductrices, qui s'étendent respectivement sur et/ou dans la plaque (5) formant support, et
- deux ou plusieurs unités (6) d'actionneur montées sur ou dans la plaque (5) formant support,
**caractérisé**
**en ce que** deux ou plusieurs unités (6) d'actionneur sont disposées en plusieurs couches (14a, 14b, 14c) dans ou sur la plaque (5) formant support qui, au moins une partie entourant les deux ou plusieurs unités (6) d'actionneur, a, pour l'incorporation de ces unités d'actionneurs, été fabriquée en une impression en 3D.

2. Fond de panier (1) suivant la revendication 1,
dans lequel au moins une unité (6) d'actionneur est constituée sous la forme d'une plaquette à circuit imprimé équipée.

3. Fond de panier (1) suivant l'une des revendications précédentes,
dans lequel au moins une unité (6) d'actionneur est constituée sous la forme d'un microsystème, notamment d'un MEMS.

4. Fond de panier (1) suivant l'une des revendications précédentes,
**caractérisé par** au moins un élément (18) de blindage monté sur les deux ou plusieurs unités (6) d'actionneur pour se protéger de champs électriques et/ou magnétiques.

5. Fond de panier (1) suivant l'une des revendications précédentes,
**caractérisé par** au moins un élément (26) de refroidissement disposé sur deux ou plusieurs unités (6) d'actionneur pour le refroidissement de l'unité (6) d'actionneur.

6. Fond de panier (1) suivant l'une des revendications précédentes,
dans lequel les deux ou plusieurs unités (6) d'actionneur sont insérées, de manière à pouvoir être retirées, dans un évidement (13) de la plaque (5) formant support.

7. Fond de panier (1) suivant la revendication 6,
dans lequel les deux ou plusieurs unités (6) d'actionneur sont, à l'aide d'éléments (16) de ressort, notamment à l'aide d'éléments (16) de ressort conducteurs de l'électricité, immobilisées dans l'évidement (13) de la plaque (5) formant support.

8. Armoire (11) de commande ayant un fond de panier (1) constituée suivant l'une des revendications précédentes.

9. Procédé de fabrication d'un fond de panier (1) constitué suivant l'une des revendications 1 à 7, dans lequel on intègre les deux ou plusieurs unités (6) d'actionneur, à disposer en plusieurs couches dans ou sur la plaque (5) formant support, dans la plaque (5) formant support par une impression en 3D.

10. Procédé suivant la revendication 9,
**caractérisé en ce que** l'on intègre les deux ou plusieurs unités (6) d'actionneur dans la plaque (5) formant support en fabricant la plaque (5) formant support au moins dans une partie entourant les deux ou plusieurs unités (6) d'actionneur par une impression en 3D, qui incorpore l'unité (6) d'actionneur dans la plaque (5) formant support.

11. Procédé suivant la revendication 9,
**caractérisé en ce que** l'on intègre les deux ou plusieurs unités (6) d'actionneur dans la plaque (5) formant support en prévoyant, dans la plaque (5) formant support, un évidement (13), dans lequel on insère les deux ou plusieurs unités (6) d'actionneur.

12. Procédé suivant l'une des revendications 9 à 11, **caractérisé en ce que** l'on imprime des pistes (7) conductrices par une impression en 3D, que l'on durcit après le dépôt sur la plaque (5) formant support et/ou les deux ou plusieurs unités (6) d'actionneur.

13. Procédé suivant l'une des revendications 9 à 12, **caractérisé en ce que** l'on imprime au moins une surface (9, 9a, 9b, 9c) de contact des deux ou plusieurs unités (6) d'actionneur, après leur intégration dans la plaque (5) formant support d'une pâte conductrice de l'électricité pour la constitution de pistes (7) conductrices.
